# EUROPEAN PATENT SPECIFICATION

(11) **EP 1 803 840 B1**
(45) Date of publication and mention of the grant of the patent: **04.02.2009**
(21) Application number: 07006992.7
(22) Date of filing: 24.12.1999
(51) Int. Cl.: C30B 29/36, C30B 23/00, C30B 23/02, C30B 25/00, C30B 25/02, C30B 25/10, C30B 25/20

(54) **Method for growing single crystal of silicon carbide**
Verfahren zur Züchtung eines Einkristalls von Siliziumcarbid
procédé pour la croissance de monocristaux de carbure de silicium

(30) Priority: 25.12.1998 JP 36856598
(43) Date of publication of application: 04.07.2007
(62) Divisional of application: 99961385.4
(73) Proprietor: SHOWA DENKO KABUSHIKI KAISHA, Tokyo 105-8518 (JP)
(72) Inventor: Yano, Kotaro, Chiba-shi Chiba 267-0056 (JP); Yamamoto, Isamu, Chiba-shi Chiba 267-0056 (JP); Shigeto, Masashi, Chiba-shi Chiba 267-0056 (JP); Nagato, Nobuyuki, Chiba-shi Chiba 267-0056 (JP)
(74) Representative: Strehl Schübel-Hopf & Partner

(56) References cited:
- PONS M ET AL: "Macroscopic modelling of silicon carbide sublimation: toward a microscopic modelling of defect formation" SURFACE AND COATINGS TECHNOLOGY ELSEVIER SWITZERLAND, vol. 94-95, no. 1-3, October 1997 (1997-10), pages 279-284, XP002433750 ISSN: 0257-8972
- PONS M ET AL: "DEFECT FORMATION AND MACROSCOPIC MODELLING OF SILICON CARBIDE SUBLIMATION PROCESS" ELECTROCHEMICAL SOCIETY PROCEEDINGS, ELECTROCHEMICAL SOCIETY, PENNINGTON, NJ, US, vol. 97-25, 5 September 1997 (1997-09-05), pages 262-269, XP009083843 ISSN: 0161-6374
- ANIKIN M ET AL: "Temperature gradient controlled SiC crystal growth" MATERIALS SCIENCE AND ENGINEERING B, ELSEVIER SEQUOIA, LAUSANNE, CH, vol. 46, no. 1-3, 1 April 1997 (1997-04-01), pages 278-286, XP004085328 ISSN: 0921-5107
- MADAR R ET AL: "Defects formation in sublimation grown 6H-SiC single crystal boules" DIAMOND AND RELATED MATERIALS, ELSEVIER SCIENCE PUBLISHERS, AMSTERDAM, NL, vol. 6, no. 10, 1 August 1997 (1997-08-01), pages 1249-1261, XP004096918 ISSN: 0925-9635

## Description

### TECHNICAL FIELD

The present invention relates to a method for growing a silicon carbide single crystal and, more specifically, the present invention relates to a method for growing a high-quality silicon carbide single crystal having a large crystal diameter or size on a seed crystal. Silicon carbide is a thermally and chemically very stable semiconductor material having a wide energy band gap and can be used as an environment-resistant-device material, a radiation-resistant-device material, a power-device material for power control, a short wavelength light-emitting device material, and the like, which are usable even at high temperatures.

### BACKGROUND ART

The silicon carbide single crystal is usually produced by a sublimation method (see, Japanese Unexamined Patent Publication (Kohyo) No. 3-501118). In the sublimation method, a silicon carbide raw material powder and a seed crystal substrate as a silicon carbide single crystal are placed in a graphite-made crucible to face each other, the crucible is heated at 1,800 to 2,400°C in an inert gas atmosphere to decompose and then gasify the silicon carbide raw material powder by heat and the generated sublimate chemical species is allowed to reach the surface of the seed crystal substrate kept at a temperature suitable for the growth of crystal, whereby the single crystal is epitaxially grown.

The silicon carbide single crystal is required to have a small number of defects because, for example, the single crystal can be advantageously used with high efficiency in the manufacture of a device from the single crystal.

In the inside of a crystal produced by a conventional method, a large number of defects are usually present. One cause of defects is considered to be as follows. As described in Japanese Unexamined Patent Publication (Kokai) No. 9-110584 and Phys. Stat. Sol. (b), vol. 202, 177-200 (1997), when a clearance is present between the back surface of the seed crystal and a holding member for holding the seed crystal, the crystal component sublimes from the clearance on the back surface of the seed crystal (hereinafter referred to as "back surface sublimation") and this gives rise to defects of the seed crystal and the grown crystal. In order to prevent this generation of defects, a method of bonding the seed crystal and the holding member by a polymer adhesive and carbonizing it under heat, as an attempt to improve the adhesive property therebetween, is used (see, for example, Japanese Unexamined Patent Publication (Kokai) No. 9-110584). However, since the polymer material originally undergoes gas generation or volume shrinkage upon carbonization, a sufficiently dense carbonized layer cannot be formed and a clearance is generated and, as a result, the defects cannot be satisfactorily prevented. In another attempt, as described in Mater. Sci. Engineering B57, 228-233 (1999), a tantalum member is disposed within the growth vessel so as to prevent the back surface sublimation. However, if silicon and a substance other than carbon are used within the growth vessel, these are taken into the crystal as undesired impurities and give rise to a decrease in the quality of the crystal.

Accordingly, a method and an apparatus for producing a high-quality silicon carbide single crystal, reduced in defects and undesired impurities, by preventing the back surface sublimation causing crystal defects are required.

Another cause of producing crystal defects is considered to be as follows. When the crystal is continuously grown for a long period of time, a polycrystal grown from the upper inner wall of the crucible comes to overwhelm the periphery of the single crystal grown on a seed crystal and thereby, strain is generated in the single crystal, giving rise to the defects. In addition, the polycrystal prevents the enlargement of aperture of the single crystal. In order to produce a crystal while not allowing a polycrystal to grow from the upper inner wall of the crucible and overwhelm the periphery of the single crystal grown on a seed crystal or for producing the single crystal with a large diameter or size, (1) a method described in Shinku (Vacuum), Vol. 30 (1987), where a seed crystal substrate is fixed to the ceiling of a graphite crucible and the inner wall of crucible is kept apart from the periphery of seed crystal substrate, so that the grown crystal can be prevented from contacting with the inner wall and thereby, the cause of inhibiting the enlargement of crystal aperture can be eliminated, or (2) a method of fixing a dividing plate having a diameter or size slightly smaller than the seed to the position at a distance of 0.1 to 2.0 mm from the seed crystal substrate so as to enlarge the crystal diameter or size (see, Japanese Unexamined Patent Publication No. 2-30699), is being used at present. In addition, a method of controlling the gradient between the seed crystal substrate and the silicon carbide raw material powder within the reaction vessel is known (see, Japanese Examined Patent Publication (Kokoku) No. 63-57400), where, however, the enlargement of the crystal aperture is not referred to.

These methods have a limit in that since the polycrystal grows at a high rate, the polycrystal comes in contact with the single crystal and at that time, the single crystal stops enlarging. In order to continue the growth, the polycrystal part overwhelming the single crystal must be removed by cutting or the like and this disadvantageously increases the operation steps and decreases the production efficiency of crystal. Furthermore, when the single crystal is overwhelmed with the polycrystal, the single crystal cannot grow to have a large diameter or size. In the method of separating the seed crystal from the upper inner wall of growth vessel, sublimation of seed crystal may disadvantageously occur depending on the production conditions.

The present invention has been made under these circumstances and the object of the present invention is to provide a silicon carbide single crystal reduced in defects and having a large aperture, and a method and an apparatus therefor.

### DISCLOSURE OF THE INVENTION

In order to achieve the above-described objects, the present invention provides.

A method for growing a silicon carbide single crystal on a silicon carbide seed crystal, as defined in the appended claims 1 to 5.

### BRIEF DESCRIPTION OF THE DRAWINGS

Fig. 1 is a cross section of an apparatus for growing a silicon carbide single crystal by a sublimation method not according to the present invention.
Fig. 2 is a cross section of an apparatus for growing a silicon carbide single crystal by a silicon gas carbon reaction method not according to the present invention.
Fig. 3 is a cross section of an apparatus for growing a silicon carbide single crystal by a sublimation method according to the present invention.
Fig. 4 is a cross section of an apparatus for growing a silicon carbide single crystal by a silicon gas carbon reaction method according to the present invention.
Fig. 5 is a cross section showing another example of the apparatus for growing a silicon carbide single crystal by a sublimation method according to the present invention.

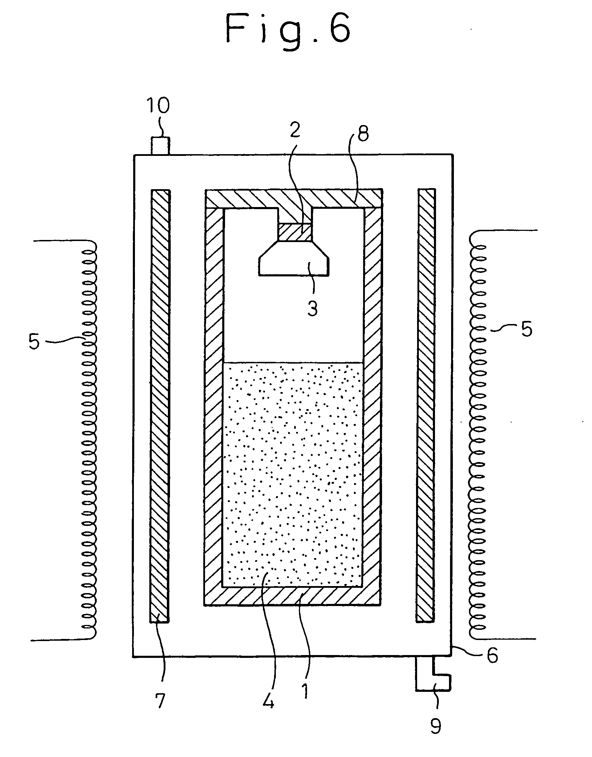

Fig. 6 is a cross section of an apparatus for growing a silicon carbide single crystal by a conventional sublimation method.

### BEST MODE FOR CARRYING OUT THE INVENTION

According to the present invention, the temperature of the growth vessel in the periphery of the seed crystal is made relatively higher than the surface temperature of the seed crystal, whereby the growth rate of a polycrystal growing on the inner wall of the growth vessel not fixed with a seed crystal in the peripheral part of the seed crystal can be reduced and the single crystal growing on the seed crystal can be prevented from being surrounded with a polycrystal growing in the periphery, as a result, it has been found that generation of strain in the single crystal can be inhibited.

For example, one of factors affecting the transfer speed of a sublimated chemical species from the silicon carbide raw material to the crystal in the sublimation method is the difference in concentration of the sublimate chemical species between the vicinity of the silicon carbide raw material and the vicinity of the surface of the seed crystal substrate. One of causes of generating the concentration difference is the difference in temperature between the silicon carbide raw material and the seed crystal surface. More specifically, since the temperature difference from the silicon carbide raw material is greater in the portion having a lower temperature in the inner wall of the growth vessel than in other portions, a greater difference in concentration of the sublimated chemical species is generated and the sublimated chemical species is fed at a higher rate. As a result, it is considered that the portion having a lower temperature in the inner wall of the growth vessel is larger in the growth rate of crystal. Furthermore, when a temperature distribution is present in each site on the upper inner wall of the growth vessel, a material also moves from the portion having a higher temperature toward the portion having a lower temperature and therefore, it is considered that the growth rate is higher in the portion having a lower temperature. By taking account of this, according to the present invention, a temperature distribution is provided to those sites between the single crystal growing in the seed crystal part and the polycrystal growing on other inner walls, whereby generation of crystal nuclei and the crystal growth rate are controlled at respective sites so as to prevent the single crystal being strained due to envelopment by a polycrystal growing in the periphery of the single crystal growing on a seed crystal.

According to this method, the silicon carbide single crystal is not inhibited by the polycrystal from enlarging the size and therefore, efficient enlargement and simplification of the process can be advantageously attained. After the size is enlarged, if desired, the single crystal may further be grown to a long and high-quality single crystal.

In order to inhibit the growth of a polycrystal on the wall surface in the periphery of the seed crystal, the temperature of the peripheral vessel wall is made from 10 to 400°C higher, preferably from 50 to 300°C higher, than the temperature on the growth surface of the seed crystal. Unless a certain degree of temperature difference is present, the effect of controlling the deposition of silicon carbide or the growth rate may not be attained, however, if the temperature difference is excessively large, the effect is saturated.

Among the peripheral wall surfaces of the seed crystal, a polycrystal growing from the vessel wall present in the back surface side of the seed crystal causes a problem in practice. Particularly, the temperature on the vessel wall facing (opposite or parallel) the back surface of the seed crystal is important. By elevating the temperature on this vessel wall to a temperature from 10 to 400°C higher than the seed crystal, a polycrystal can be prevented, or suppressed, from growing on the peripheral vessel wall including the back surface side of the seed crystal. In the silicon carbide-forming gas feed part side from the seed crystal of the growth vessel, the temperature is rendered higher than the temperature of the seed crystal and the temperature on the peripheral vessel wall is always higher than the temperature of the seed crystal. The vessel wall facing the back surface of the seed crystal generally has a lowest temperature in the back surface side of the seed crystal and therefore, if the temperature of this portion can be made higher than the temperature of the seed crystal, the temperature can be higher in all peripheral portions of the seed crystal than the temperature of the seed crystal.

As described above in the first aspect of the present invention, in the case where the temperature gradient in the back surface side of the seed crystal is zero or a positive value, the temperature on the vessel wall in the back surface side of the seed crystal is generally higher than the temperature of the seed crystal and the object of preventing the growth of a polycrystal in the back surface side of the seed crystal can be achieved in many cases, however, in order to achieve the object in the second aspect of the present invention, it is necessary to provide a temperature difference without fail between the temperature of the seed crystal, particularly on the crystal growth surface and the temperature on the vessel wall surface in the back surface side. This object can be achieved by designing the shape of the growth vessel or the heating or cooling means.

In the case of heating the silicon carbide-forming gas feed part and the back surface side of the seed crystal, the heating is preferably performed to have the lowest temperature at the position of seed crystal.

In order to have a high temperature on the peripheral vessel wall as compared with the seed crystal, a method of heating the inside of the vessel may be used as described above but, in addition, this may also be achieved by setting the heat dissipation from the seed crystal higher than the heat dissipation from the peripheral vessel wall. In other words, when a member having a heat conductivity higher than that of the vessel wall is used for the seed crystal-holding member, cooling of the seed crystal proceeds and a temperature lower than the temperature of the peripheral vessel wall can be realized.

In the case where the seed crystal-holding member is designed to have a high heat dissipation, even if the temperature of the seed crystal is not always lower than the ambient temperature, the temperature of the seed crystal approximates to the temperature on the peripheral vessel wall and an effect of relatively inhibiting the deposition and growth of a polycrystal silicon carbide on the vessel wall surface is provided. This is useful for enhancing the quality and attaining a large size of the silicon carbide single crystal. This invention using a member having such heat dissipation property has no relationship with the temperature distribution and therefore, establishes one independent aspect of the present invention (third aspect).

In the growth vessel for use in the present invention, the portion of housing and heating a raw material or the portion of housing and heating silicon and carbon and growing silicon carbide by the reaction therebetween is suitably formed of a carbon material, usually graphite, however, as long as it is a carbon material, any can be used irrespective of being crystalline or amorphous. For the member of holding the seed crystal in the growth vessel or the peripheral member thereof, all carbon materials may be used irrespective of crystalline or amorphous. For the holding, a method of fixing the seed crystal to the holding member or mechanically combining these may be used.

In the following, a case where a member having higher heat dissipation than that of the peripheral member is used for the member holding the seed crystal to partially create a portion different in the heat dissipation and thereby partially form a low-temperature part in the inner wall part, is described. The materials different in the heat dissipation means that in the case of an isotropic construction material, the construction materials are originally different in heat conductivity and in the case of anisotropic construction material, not only the construction materials are originally different in the heat conductivity but also same construction materials are combined to differ in the direction of material composition. The ratio of the heat conductivity in the portion having high heat dissipation to the heat conductivity in the portion having low heat dissipation is preferably from 1.1 to 1,000, more preferably from 2 to 500, still more preferably from 5 to 300. If the ratio is less than 1.1, a sufficiently large difference in the heat dissipation may not be obtained and the temperature distribution cannot be satisfactorily controlled, whereas if the ratio exceeds 1,000, the temperature difference becomes excessively large due to large difference in the heat dissipation and strain is readily generated in the crystal. In the case of combining materials different in the heat dissipation, from the standpoint of effectively using the raw material, the gap between materials is preferably reduced as much as possible to prevent a growth gas from leaking.

The anisotropic material is described in detail below. The material used is preferably pyrographite carbon (heat conductivity in the C-axis perpendicular direction: 2,000 W/m⁻¹K⁻¹, heat conductivity in the C-axis parallel direction: 9.5 W/m⁻¹K⁻¹ (300 K)) having anisotropic heat conductivity. In this case, for example, when an anisotropic material is used for the member of holding the seed crystal by making the C-axis perpendicular to the direction from the inside of the growth vessel toward the outside, the heat conductivity in the portion of holding the seed crystal can be made relatively large as compared with the peripheral portion thereof and, by accelerating the heat dissipation from the seed crystal, the temperature distribution can be controlled. Furthermore, when an anisotropic material is used for the peripheral member by disposing it in the direction of the C axis in parallel with the direction from the inside of the growth vessel toward the outside, the heat conductivity in the portion of holding the seed crystal can be made large as compared with the peripheral portion thereof. For the carbon material having anisotropic heat conductivity, a carbon fiber-carbon composite material, so-called CC composite, described in Fukugo Zairyo wo Shiru Jiten (Dictionary for Knowing Composite Material), Agune 115 (1982), may also be used.

In the case of using a growth vessel having disposed therein a material having anisotropic heat conductivity and controlling the inner temperature of the inner wall from the outside, a growth vessel where a carbon material having anisotropic heat conductivity is used at least for the seed crystal-holding member by laying the direction having large heat conductivity parallel to the direction of heat dissipation may be used, for example, a growth vessel where a material having anisotropy in the heat conduction facility is disposed such that the heat conduction facility in the direction from the inside of the growth vessel toward the outside is large or such that the heat conduction facility in the direction toward the inner wall surface of the growth vessel is small. Of course, the present invention includes a case of using a material having anisotropy for the entire growth vessel. By using such a growth vessel and by forming a cut in the growth vessel or externally performing local control from the outer wall of the growth vessel using an additionally disposed cooling device or the like, the temperature distribution within the growth vessel can be locally controlled with good efficiency as compared with the case of using a conventional isotropic homogeneous material.

In the present invention, formation of a cut in the growth vessel and application of additional cooling from the outside are not excluded.

By using the method and the apparatus for growing a silicon carbide single crystal according to the second and third aspects of the present invention, a high-quality silicon carbide single crystal reduced in strain or defects and having a large crystal aperture can be efficiently produced even when the crystal growth is continued for a long period of time, while preventing a polycrystal growing on the upper inner wall of the growth vessel from overwhelming the periphery of the single crystal growing on the seed crystal.

The apparatus for growing a crystal according to the practical embodiment of the present invention is described below by referring to the attached drawings.

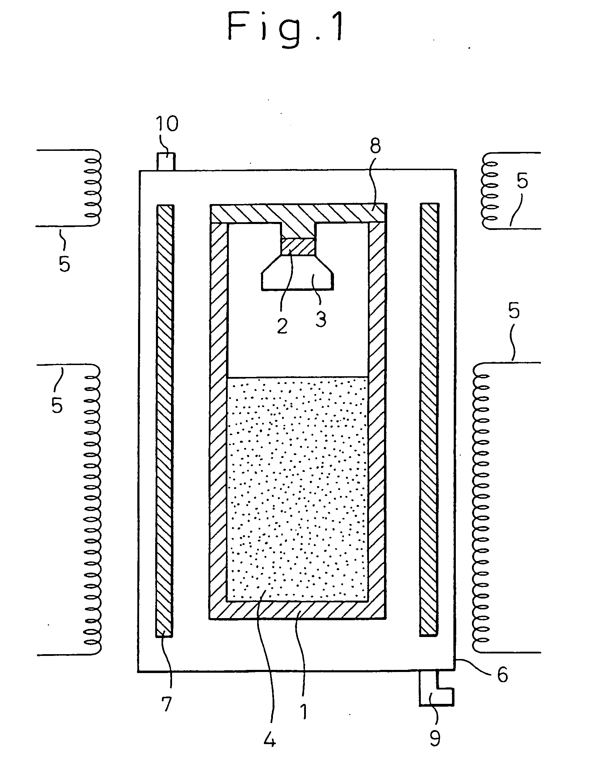

In the embodiments shown in Figs. 1 to 5, the inner diameter of the growth vessel is substantially larger than the size of the seed crystal and therefore, the silicon carbide single crystal growing on the surface of the seed crystal 2 can be grown while it enlarges not only in the thickness direction but also in the width direction, whereby a high-quality and large-size silicon carbide single crystal can be produced. After reaching a large size, the silicon carbide single crystal can be grown only in the longitudinal direction while not changing the size by selecting the shape and the inner diameter of the growth vessel.

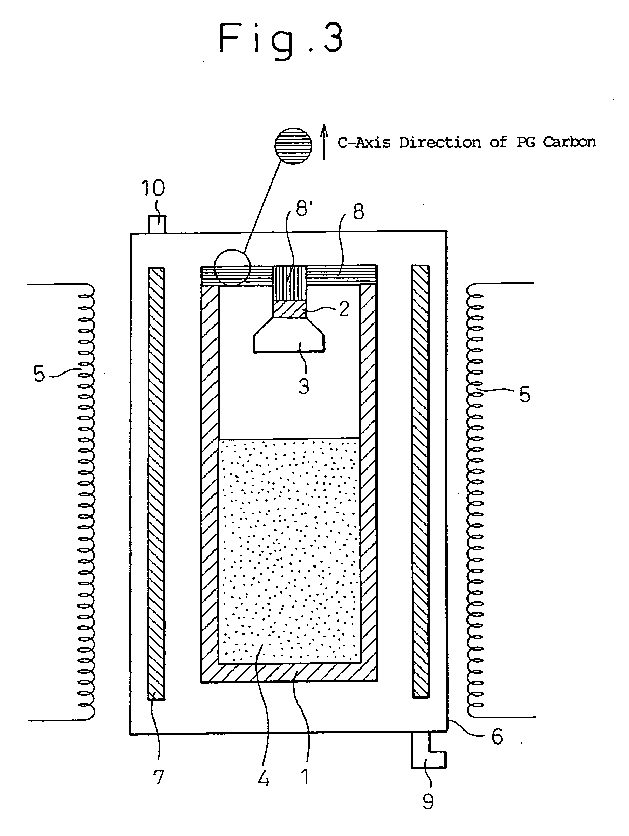

An example of the present invention using a sublimation method is described below by referring to Fig. 3, where the seed crystal-holding member has heat dissipation higher than the heat dissipation of the peripheral members and thereby the growth of a polycrystal from the periphery of the seed crystal is prevented.

The apparatus of Fig. 3 is the same as the apparatus shown in Fig. 1 except for crucible cap 8,8'. The cap 8,8' comprises a cap body 8 and a holding member 8' for the seed crystal 2. By using pyrographite carbon having anisotropy in heat conductivity for the holding member 8' and laying the C axis thereof in the parallel direction, the heat conductivity in the vertical direction from the seed crystal 2 toward the outside of the crucible through the holding member 8' can be made 1,000 times higher than that in the direction perpendicular to the C axis. Accordingly, when pyrographite carbon is used for the cap body 8 while laying the C axis in the vertical direction, the heat conductivity of the crucible cap 8 in the vertical direction can be reduced to 1/1,000 of the heat conductivity of the holding member 8'. As a result, the seed crystal 2 is more cooled than the crucible cap and reaches a lower temperature. In turn, the deposition and growth of a silicon carbide polycrystal on the surface of the crucible cap 8 is prevented or inhibited. Even when an amorphous carbon material other than pyrographite is used for the crucible cap 8, a significant difference in the heat dissipation from the holding member 8' can be provided.

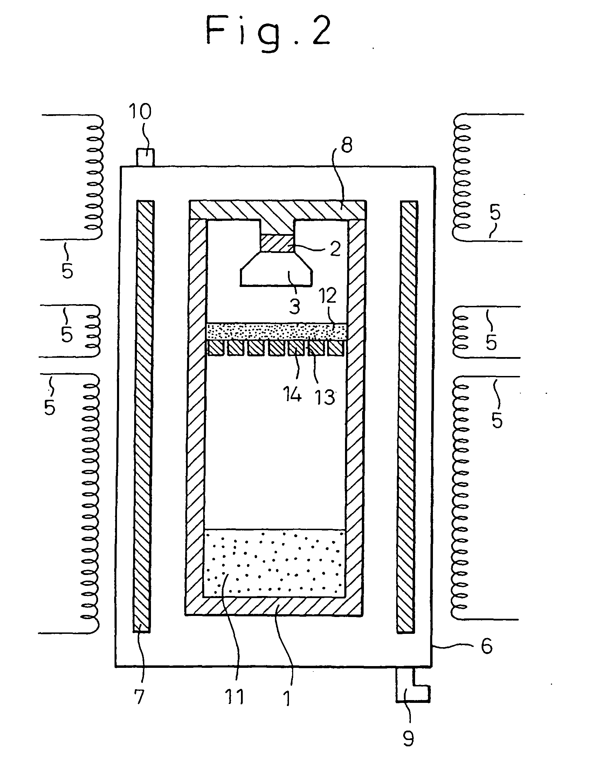

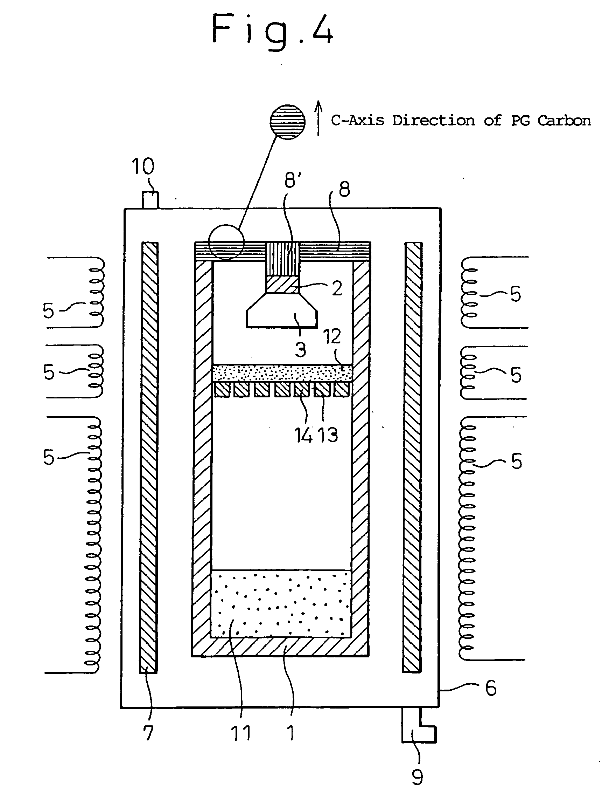

Fig. 4 is a view showing an apparatus for use in the silicon gas carbon reaction method, using the same seed crystal-holding member as in Fig. 3. The construction thereof comprises the same apparatus body as in Fig. 2 and the same holding material as in Fig. 3.

### EXAMPLES

The present invention is described in greater detail below by referring to specific examples, however, the present invention should not be construed as being limited thereto.

### Example 1

This is an example of producing a silicon carbide single crystal by a sublimation method. The production was performed using an apparatus shown in Fig. 3. In Fig. 3, a graphite crucible 1 is used for the portion of housing and heating the raw material in a growth vessel. A seed crystal 2 ((0001) plane of 6H-SiC single crystal, diameter: 10 mm, thickness: 1.0 mm) was adhered and held on a holding member 8' of the pyrographite carbon-made crucible cap 8. As shown in Fig. 3, the pyrographite carbon-made crucible cap 8 used had a combination of directivities different in the heat conductivity. The holding member 8 having attached thereto the seed crystal 2 was composed as shown in Fig. 3 to lay the C axis of the pyrographite carbon in the horizontal direction and had high heat conductivity in the direction from the inside toward the outside of the graphite crucible 1. On the other hand, the body of the crucible cap 8 was composed to lay the C axis of the pyrographite carbon in the vertical direction and had low heat conductivity in the direction from the inside toward the outside of the graphite crucible 1. The distance between the crystal growth surface of the seed crystal 2 and the inner surface of the crucible cap 8 body was 4 mm.

Within the graphite crucible 1, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside a high-frequency heating coil 5. The crystal growth surface of the seed crystal 2 was positioned at 20 mm lower from the upper end of the high-frequency coil 5.

The inside of the reaction cylinder 6 was evacuated from the gas outlet 9 to reduce the pressure to 0.01 torr (1.33 Pa) and after filling an argon gas from the inert gas inlet 10 to an atmospheric pressure, again evacuated from the gas outlet 9 to reduce the pressure to 0.0005 torr (0.065 Pa) and thereby expel air inside the reaction cylinder 6. Thereafter, an argon gas was filled from the inert gas inlet 10 to an atmospheric pressure, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,100°C, respectively, the argon atmosphere pressure was reduced to 200 torr (26.6 kPa) by the evacuation from the gas outlet 9 and in this state, a silicon carbide single crystal 3 was grown. The temperature was controlled by measuring the temperature in the outer wall side of the graphite crucible 1 using a radiation thermometer. The temperature in the inner wall side of the crucible cap 8 was 2,100°C at the center portion having high heat dissipation, from 2,150 to 2,250°C at the peripheral portion thereof and 2,200°C on average.

The growth of a polycrystal large enough to overwhelm the periphery of the single crystal grown on the seed crystal was not confirmed.

The grown crystal had a grown thickness of 4.5 mm in the longitudinal direction and a grown amount of 7.0 mm in the diameter direction. From the peak position by Raman spectrometry and the peak pattern by the X-ray diffraction, this crystal was identified as 6H-SiC single crystal completely free of mixing with other polymorphisms.

### Example 2

This is an example of producing a silicon carbide single crystal by a silicon gas carbon reaction method. The production was performed using an apparatus shown in Fig. 4.

In Fig. 4, a graphite crucible 1 is used for the portion of housing and heating the raw material in a growth vessel. A seed crystal substrate 2 ((0001) plane of 6H-SiC single crystal, diameter: 7 mm, thickness: 1.0 mm) was adhered and held on a pyrographite carbon-made crucible cap 8. As shown by the C-axis direction of PG carbon in Fig. 4, the pyrographite carbon (PG carbon)-made crucible cap 8 used was composed by a combination of members having different heat conductivity directivities. The member having attached thereto the seed crystal 2 was a member having high heat conductivity, as shown in Fig. 2, in the direction from the inside toward the outside of the graphite crucible 1.

As shown in Fig. 4, 23 g of silicon raw material 11 (Si grains of semiconductor grade) was housed in the graphite crucible 1. The graphite crucible 1 had an outer diameter of 32 mm, a height of 121 mm and a wall thickness of 4 mm. A carbon plate 14 having a thickness of about 2 mm (having 21 holes of 3 mmφ) was fixed at about 20 mm from the pyrographite carbon-made crucible cap 8 so as to support carbon powder 12 and thereon, 2.4 g of carbon powder 12 (SHOKALIZER L, produced by Showa Denko K.K.) was filled. The carbon plate 14 used had through holes 13. This graphite crucible 1 was wrapped with a heat insulating material 7 and set within a reaction cylinder 6 inside a high-frequency heating container 5.

The inside of the reaction cylinder 6 was evacuated from the gas outlet 9 to reduce the pressure to 0.01 torr and, after filling an argon gas from the inert gas inlet 10 to an atmospheric pressure, again evacuated from the gas outlet 9 to reduce the pressure to 0.0005 torr and thereby expel air inside the reaction cylinder 6. Thereafter, an argon gas was filled from the inert gas inlet 10 to an atmospheric pressure. Then, the pressure was reduced to 10 torr (13.3 Pa) by the evacuation from the gas outlet 9 while heating the graphite crucible 1 and a silicon carbide single crystal 3 was grown while keeping the temperatures of silicon raw material 11, carbon powder 12 and seed crystal 2 at 1,800°C, 2,500°C and 2,000°C, respectively, for 3 hours. The temperature was controlled by measuring the temperature in the outer wall side of the graphite crucible 1 using a radiation thermometer.

The growth of a polycrystal large enough to overwhelm the periphery of the single crystal grown on the seed crystal was not confirmed.

The grown crystal had a grown amount of 5.0 mm in the longitudinal direction and a grown amount of 7.8 mm in the diameter direction. From the peak position by Raman spectrometry and the peak pattern by the X-ray diffraction, this crystal was identified as 6H-SiC single crystal completely free of mixing with other polymorphisms.

### Example 3

This is an example of producing a silicon carbide single crystal by a sublimation method. The production was performed using an apparatus shown in Fig. 3 except for using a graphite-made crucible cap 15. A seed crystal 2 ((0001) plane of 6H-SiC single crystal, diameter: 10 mm, thickness: 1.0 mm) was adhered and held on the graphite-made crucible cap 15. The graphite-made crucible cap 15 was composed of a combination of materials different in heat conductivity using a material having high heat conductivity (120 kcal/mhr°C) for the holding member 8' having attached thereto the seed crystal 2 and a material having low heat conductivity (70 kcal/mhr°C) for the body member of the cap 8.

Within the graphite crucible 1, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside a high-frequency heating container 5.

The inside of the reaction cylinder 6 was evacuated from the gas outlet 9 to reduce the pressure to 0.01 torr and, after filling an argon gas from the inert gas inlet 10 to an atmospheric pressure, again evacuated from the gas outlet 9 to reduce the pressure to 0.0005 torr and thereby expel air inside the reaction cylinder 6. Thereafter, an argon gas was filled from the inert gas inlet 10 to an atmospheric pressure, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,200°C, respectively, the argon atmosphere pressure was reduced to 200 torr by the evacuation from the gas outlet 9 and in this state, a silicon carbide single crystal 3 was grown. The temperature was controlled by measuring the temperature in the outer wall side of the graphite crucible 1 using a radiation thermometer. The temperature in the inner wall side of the graphite crucible 1 was 2,200°C at the center portion composed of a material 8' having high heat conductivity, from 2,240 to 2,280°C at the peripheral member and 2,260°C on average.

The growth of a polycrystal large enough to overwhelm the periphery of the single crystal grown on the seed crystal was not confirmed.

The grown crystal had a grown thickness of 3.5 mm in the longitudinal direction and a grown amount of 3.2 mm in the diameter direction. From the peak position by Raman spectrometry and the peak pattern by the X-ray diffraction, this crystal was identified as 6H-SiC single crystal completely free of mixing with other polymorphisms.

### Example 4

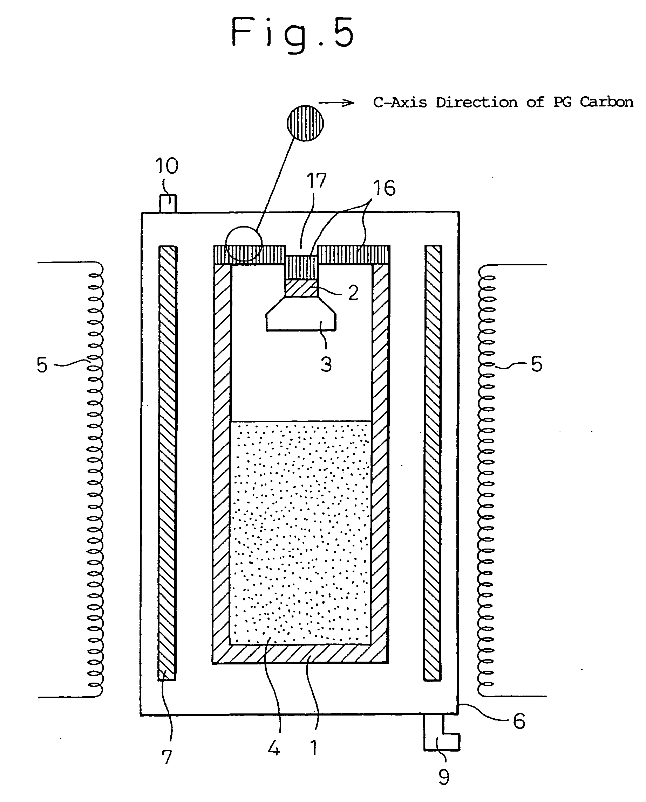

This is an example of producing a silicon carbide single crystal by a sublimation method. The production was performed using an apparatus shown in Fig. 5. In Fig. 5, a graphite crucible 1 is used for the portion of housing and heating the raw material in a growth vessel. As shown by the C-axis direction in Fig. 5, the entire pyrographite carbon-made crucible cap 16 was composed by combining a direction having large anisotropy in the heat conductivity with a direction of heat dissipation from the inside toward the outside of the graphite crucible 1, and a cut 17 for dissipating heat was formed so as to control the temperature. Furthermore, a cooling device (not shown) was used for controlling the temperature from the outside. A seed crystal 2 ((0001) plane of 6H-SiC single crystal, diameter: 10 mm, thickness: 1.0 mm) was adhered and held on the pyrographite carbon-made crucible cap 16. As shown in Fig. 5, the pyrographite carbon-made crucible cap 16 was composed by a single material.

Within the graphite crucible 1, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside a high-frequency heating container 5.

The inside of the reaction cylinder 6 was evacuated from the gas outlet 9 to reduce the pressure to 0.01 torr and, after filling an argon gas from the inert gas inlet 10 to an atmospheric pressure, again evacuated from the gas outlet 9 to reduce the pressure to 0.0005 torr and thereby expel air inside the reaction cylinder 6. Thereafter, an argon gas was filled from the inert gas inlet 10 to an atmospheric pressure, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,200°C, respectively, the argon atmosphere pressure was reduced to 200 torr by the evacuation from the gas outlet 10 and in this state, a silicon carbide single crystal 3 was grown. The temperature was controlled by measuring the temperature in the outer wall side of the graphite crucible 1 using a radiation thermometer. The temperature on the outer wall surface of the graphite crucible 1 was 2,200°C at the cutting part 17, from 2,250 to 2,290°C at the periphery thereof and 2,270°C on average.

The growth of a polycrystal large enough to overwhelm the periphery of the single crystal grown on the seed crystal was not confirmed.

The grown crystal had a grown thickness of 2.5 mm in the longitudinal direction and a grown amount of 3.0 mm in the diameter direction. From the peak position by Raman spectrometry and the peak pattern by the X-ray diffraction, this crystal was identified as 6H-SiC single crystal completely free of mixing with other polymorphisms.

### Comparative Example

This is an example of producing a silicon carbide single crystal by a sublimation method. The production was performed using an apparatus shown in Fig. 4 except for using a graphite-made cap having uniform heat conductivity (heat conductivity: 100 kcal/mhr°C) by a conventional technique. A seed crystal 2 ((0001) plane of 6H-SiC single crystal, diameter: 10 mm, thickness: 1.0 mm) was adhered and held on the graphite-made cap.

Within a graphite crucible 1 using the same construction material as the cap, 170 g of silicon carbide raw material powder 4 (GC-1, #100, produced by Showa Denko K.K.) was housed. The graphite crucible 1 had a diameter of 60 mm and a height of 100 mm. This graphite crucible 1 was wrapped with a heat insulating material 7 and set within a reaction cylinder 6 inside a high-frequency heating container 5.

The inside of the reaction cylinder 6 was evacuated from the gas outlet 9 to reduce the pressure to 0.01 torr and after filling an argon gas from the inert gas inlet 10 to an atmospheric pressure, again evacuated from the gas outlet 9 to reduce the pressure to 0.0005 torr and thereby expel air inside the reaction cylinder 6. Thereafter, an argon gas was filled from the inert gas inlet 10 to an atmospheric pressure. Then, a heat treatment of elevating the temperature of the graphite crucible 1 to 1,500°C and keeping it for 30 minutes was performed, the temperature of the silicon carbide raw material powder 4 and the temperature of the seed crystal 2 were elevated to 2,300°C and 2,100°C, respectively, the argon atmosphere pressure was reduced to 200 torr by the evacuation from the gas outlet 9 and, in this state, a silicon carbide single crystal 3 was grown. The temperature set was controlled by measuring the temperature in the outer wall side of the graphite crucible 1 using a radiation thermometer. The temperature on the inner wall surface of the graphite crucible 1 was 2,100°C at the center part, from 2,080 to 2,100°C at the periphery thereof and 2,090°C on average.

A polycrystal overwhelmed the periphery of the single crystal and, to enlarge the single crystal aperture, cutting of the polycrystal was necessary. The grown crystal had a grown thickness of 2.5 mm in the longitudinal direction and a grown amount of 1.2 mm in the diameter direction.

## Claims

1. A method for growing a silicon carbide single crystal on a silicon carbide seed crystal, comprising holding a silicon carbide seed crystal within a growth vessel,
providing a silicon carbide-forming gas feed part in the first surface side of the silicon carbide seed crystal, and feeding a silicon carbide-forming gas from the silicon carbide-forming gas feed part to the first surface of the silicon carbide seed crystal, wherein the first surface of the silicon carbide seed crystal has a first temperature, the silicon carbide-forming gas feed part has a second temperature higher than said first temperature and,
therefore, a silicon carbide single crystal is grown on the first surface of the silicon carbide seed crystal,
wherein the first surface of the silicon carbide seed crystal has a first temperature and the wall surface of the growth vessel surrounding in the periphery of the silicon carbide seed crystal has a third temperature higher than said first temperature, wherein a holding member is provided to project inside the growth vessel from the vessel wall of the growth vessel and hold the silicon carbide seed crystal at its distal end, said holding member passes through said first vessel wall, said holding member is higher in the heat dissipation than said surrounding vessel wall and said third temperature is higher than said first temperature.

2. The method for growing a silicon carbide single crystal as claimed in claim 1, wherein said holding member is rendered to have heat dissipation higher than that of said surrounding vessel wall by forming said holding member using a carbon material having heat conductivity anisotropy such that the heat conductivity is higher in the heat dissipation direction than in other directions.

3. The method for growing a silicon carbide single crystal as claimed in claim 1, wherein said third temperature is from 10 to 400°C higher than said first temperature.

4. The method for growing a silicon carbide single crystal as claimed in claim 2, wherein a carbon material having heat conductivity anisotropy such that the heat conductivity is lower in the heat dissipation direction than in other directions is used for said first vessel wall.

5. The method for growing a silicon carbide single crystal as claimed in claim 2, wherein both said carbon material having heat conductivity anisotropy used for said holding member and said first vessel wall are pyrographite carbon.

## Patentansprüche

1. Verfahren zum Züchten eines Siliciumcarbideinkristalls auf einem Siliciumcarbidkeimkristall, umfassend das Halten eines Siliciumcarbidkeimkristalls in einem Züchtungsgefäß, das Bereitstellen eines Siliciumcarbid-bildenden Gaseinspeisungsteils in der ersten Oberflächenseite des Siliciumcarbidkeimkristalls, und das Einspeisen eines Siliciumcarbid-bildenden Gases aus dem Teil zum Einspeisen von Siliciumcarbid-bildendem Gas auf die erste Oberfläche des Siliciumcarbidkeimkristalls, wobei die erste Oberfläche des Siliciumcarbidkeimkristalls eine erste Temperatur hat, das Teil zum Einspeisen eines Siliciumcarbid-bildenden Gases eine zweite Temperatur hat, die höher als die erste Temperatur ist, so dass auf der ersten Oberfläche des Siliciumcarbidkeimkristalls ein Siliciumcarbideinkristall gezüchtet wird, wobei die erste Oberfläche des Siliciumcarbidkeimkristalls eine erste Temperatur hat und die Wandoberfläche des Züchtungsgefäßes, welche die Ränder des Siliciumcarbidkeimkristalls umgibt, eine dritte Temperatur hat, die höher ist als die erste Temperatur, wobei ein Halteteil so angebracht ist, daß es von der Gefäßwand des Züchtungsgefäßes in das Innere des Züchtungsgefäßes hineinreicht und den Siliciumcarbidkeimkristall an dessen entferntem Ende hält, wobei das Halteteil die erste Gefäßwand durchdringt, wobei das Halteteil eine höhere Wärmeabgabe zeigt als die umgebende Gefäßwand und die dritte Temperatur höher ist als die erste Temperatur.

2. Verfahren zum Züchten eines Siliciumcarbideinkristalls nach Anspruch 1, wobei bewirkt wird, dass das Halteteil eine höhere Wärmeabgabe aufweist als die umgebende Gefäßwand, indem das Halteteil unter Verwendung eines Kohlenstoffmaterials mit einer Wärmeleitfähigkeitsanisotropie gebildet wird, so dass die Wärmeleitfähigkeit in der Wärmeabgaberichtung höher ist als in anderen Richtungen.

3. Verfahren zum Züchten eines Siliciumcarbideinkristalls nach Anspruch 1, wobei die dritte Temperatur 10 bis 400°C höher ist als die erste Temperatur.

4. Verfahren zum Züchten eines Siliciumcarbideinkristalls nach Anspruch 2, wobei für die erste Gefäßwand ein Kohlenstoffmaterial mit einer Wärmeleitfähigkeitsanisotropie eingesetzt wird, so dass die Wärmeleitfähigkeit in der Wärmeabgaberichtung niedriger ist als in anderen Richtungen.

5. Verfahren zum Züchten eines Siliciumcarbideinkristalls nach Anspruch 2, wobei sowohl das für das Halteteil eingesetzte Kohlenstoffmaterial mit Wärmeleitfähigkeitsanisotropie als auch die erste Gefäßwand Pyrographitkohlenstoff sind.

## Revendications

1. Procédé de croissance d'un monocristal de carbure de silicium sur un germe de cristallisation de carbure de silicium, comprenant
le maintien d'un germe de cristallisation de carbure de silicium à l'intérieur d'un récipient de croissance,
la mise à disposition d'une partie d'alimentation en gaz formant du carbure de silicium dans le premier côté de surface du germe cristallin de carbure de silicium et
l'amenée d'un gaz formant du carbure de silicium de la partie d'alimentation en gaz formant du carbure de silicium à la première surface du germe de cristallisation de carbure de silicium, où la première surface du germe de cristallisation de carbure de silicium a une première température, la partie d'alimentation en gaz formant du carbure de silicium a une seconde température supérieure à ladite première température et par conséquent, un monocristal de carbure de silicium croît sur la première surface du germe de cristallisation de carbure de silicium, où la première surface du germe de cristallisation de carbure de silicium a une première température et la surface de paroi d'entourage du récipient de croissance à la périphérie du germe de cristallisation de carbure de silicium a une troisième température supérieure à ladite première température, où un élément de retenue est prévu pour faire saillie à l'intérieur du récipient de croissance à partir de la paroi du récipient de croissance et maintenir le germe de cristallisation de carbure de silicium à son extrémité distale, ledit élément de retenue traverse ladite première paroi du récipient, ledit élément de retenue a une dissipation thermique supérieure à celle de ladite paroi d'entourage du récipient et ladite troisième température est supérieure à ladite première température.

2. Procédé de croissance d'un monocristal de carbure de silicium selon la revendication 1, où il est fait en sorte que ledit élément de retenue ait une dissipation thermique supérieure à celle de ladite paroi d'entourage du récipient en formant ledit élément de retenue par recours à un matériau de carbone ayant une anisotropie de conductivité thermique telle que la conductivité thermique est plus élevée dans la direction de dissipation thermique que dans d'autres directions.

3. Procédé de croissance d'un monocristal de carbure de silicium selon la revendication 1, où ladite troisième température est de 10 à 400°C supérieure à ladite première température.

4. Procédé de croissance d'un monocristal de carbure de silicium selon la revendication 2, où un matériau de carbone ayant une anisotropie de conductivité thermique telle que la conductivité thermique est plus faible dans la direction de dissipation thermique que dans d'autres directions est utilisé pour ladite première paroi de récipient.

5. Procédé de croissance d'un monocristal de carbure de silicium selon la revendication 2, où ledit matériau de carbone ayant une anisotropie de conductivité thermique utilisé pour ledit élément de retenue et ladite première paroi de récipient sont du carbone de pyrographite.
